# EUROPÄISCHE PATENTANMELDUNG

(11) **EP 0 677 747 A2**
(43) Veröffentlichungstag der Anmeldung: **18.10.1995**
(21) Anmeldenummer: 95103811.6
(22) Anmeldetag: 16.03.1995
(51) Int. Cl.: G01R 15/06, F02P 17/00, G01R 31/00

(54) **Kapazitiver Sensor zum Erfassen von Hochspannungssignalen**

(30) Priorität: 13.04.1994 DE 4412642
(71) Anmelder: ROBERT BOSCH GMBH, 70442 Stuttgart (DE)
(72) Erfinder: Bumen, Werner, D-73230 Kirchheim (DE); Kleger, Bruno, Ing., F-73340 Amstetten (DE)

(57) **Zusammenfassung**

Es wird ein kapazitiver Sensor zum Erfassen von Hochspannungssignalen vorgeschlagen, der mit einem ersten Klemmteil (10) und mit einem zweiten Klemmteil (12), welches mit dem ersten Klemmteil (10) über ein elastisches Element (13a, 13b) verbunden ist, an ein Hochspannungskabel (21) klemmbar ist. Das zweite Klemmteil (12) ist gegenüber dem ersten Klemmteil (10) in einer Längsrichtung (11) des ersten Klemmteils (10) verschiebbar angeordnet. Der erfindungsgemäße kapazitive Sensor ist insbesondere geeignet zur Verwendung mit einem Motortester (18), der zum Überprüfen der Zündanlage einer fremdgezündeten Brennkraftmaschine vorgesehen ist.

Der erfindungsgemäße kapazitive Sensor ermöglicht eine einfache Handhabung und bietet eine hohe Sicherheit gegenüber Hochspannungsdurchschlägen oder Hochspannungsüberschlägen.

## Beschreibung

### Stand der Technik

Die Erfindung geht aus von einem kapazitiven Sensor zum Erfassen von Hochspannungssignalen nach der Gattung des Hauptanspruchs. Ein derartiger Sensor ist beispielsweise aus der US-PS 4,758,791 bekannt. Der vorbekannte kapazitive Sensor enthält zwei gegeneinander bewegbare Klemmteile, die über eine Feder miteinander verbunden sind. Die beiden Klemmteile bilden die Backen einer Zange, die an ein Hochspannungskabel anklemmbar ist. Die beiden Klemmteile sind aus elektrisch leitfähigem Material gefertigt und bilden mit dem Innenleiter des Hochspannungskabels einen Kondensator, dessen Dielektrikum durch die Isolation des Kabels gegeben ist.

Der Erfindung liegt die Aufgabe zugrunde, einen kapazitiven Sensor zum Erfassen von Hochspannungssignalen anzugeben, der einfach in der Handhabung ist und der eine hohe Sicherheit gegenüber Hochspannungsüberschlägen bietet.

Die Aufgabe wird durch die im Hauptanspruch angegebenen Merkmale gelöst.

### Vorteile der Erfindung

Der erfindungsgemäße kapazitive Sensor weist den Vorteil einer hohen Sicherheit gegenüber Hochspannungsüberschlägen oder Hochspannungsentladungen auf. Erreicht wird die hohe Sicherheit durch eine weitgehend geschlossene Ausführung des kapazitiven Sensors, wobei keine offenen Metallflächen im Koppelbereich zum Hochspannungskabel vorhanden sind. Die Verschiebung eines zweiten Klemmteils gegenüber einem ersten Klemmteil in einer Längserstreckung des ersten Klemmteils ermöglicht eine bequeme Einhandbedienung des kapazitiven Sensors. Das Einklemmen des Hochspannungskabels ermöglicht eine Anpassung an verschiedene Durchmesser der Hochspannungskabel, wobei gewährleistet ist, daß die sich ergebende Luftspaltkapazität zwischen dem Hochspannungskabel und wenigstens einem Klemmteil einen definierten Wert annimmt. In Abhängigkeit von der Ausgestaltung wenigstens eines Klemmteils an der Auflagestelle des Hochspannungskabels kann, zumindest für einen vorgegebenen Durchmesser des Hochspannungskabels, die Luftspaltkapazität zu Null gemacht werden. Die feste Einklemmung des Hochspannungskabels verhindert, daß das Hochspannungskabel während der Messung aus dem kapazitiven Sensor herausfällt. Eine sichere Einklemmung des Hochspannungskabels ist auch bei erhöhter Temperatur des Hochspannungskabels gewährleistet, bei der die Isolation weich werden kann. Eine solche erhöhte Temperatur tritt beispielsweise bei als Zündkabel ausgebildeten Hochspannungskabeln auf, die im Motorraum eines Kraftfahrzeugs angeordnet sind.

Vorteilhafte Weiterbildungen und Ausgestaltungen des erfindungsgemäßen kapazitiven Sensors ergeben sich aus abhängigen Ansprüchen.

Eine vorteilhafte Ausgestaltung sieht vor, daß in demjenigen Klemmteil, das ein elektrisch leitfähiges Teil enthält, welches mit dem Hochspannungskabel einen Kondensator bildet, eine elektrisch leitfähige Schicht vorgesehen ist, die das Hochspannungskabel zumindest teilweise umschließt, wobei die Schicht innerhalb des Klemmteils angeordnet ist.

Eine vorteilhafte Weiterbildung der beschriebenen Ausgestaltung sieht vor, daß die elektrisch leitfähige Schicht keine Verbindung mit dem elektrisch leitfähigen Teil aufweist. Diese Maßnahme erhöht die Sicherheit gegenüber Hochspannungsdurchschlägen. Weiterhin kann mit der elektrisch leitfähigen Schicht die Koppelkapazität zwischen dem Hochspannungskabel und dem elektrisch leitfähigen Teil erhöht werden.

Gemäß einer vorteilhaften Ausgestaltung ist vorgesehen, daß das zweite Klemmteil, das gegenüber dem ersten Klemmteil verschiebbar ist, vollständig aus Isoliermaterial hergestellt ist. Der Verzicht auf elektrisch leitfähige Teile im zweiten Klemmteil erhöht weiter die elektrische Sicherheit von Bedienpersonen, welche die Adapiton des kapazitiven Sensors an unter Spannung stehenden Hochspannungskabeln vornehmen.

Eine bevorzugte Verwendung des erfindungsgemäßen kapazitiven Sensors ist gegeben in Verbindung mit einem Motortester, der zum Überprüfen der Zündung einer fremdgezündeten Brennkraftmaschine vorgesehen ist.

Weitere vorteilhafte Ausgestaltungen und Verbesserungen des erfindungsgemäßen kapazitiven Sensors ergeben sich aus weiteren abhängigen Ansprüchen in Verbindung mit der folgenden Beschreibung.

### Zeichnung

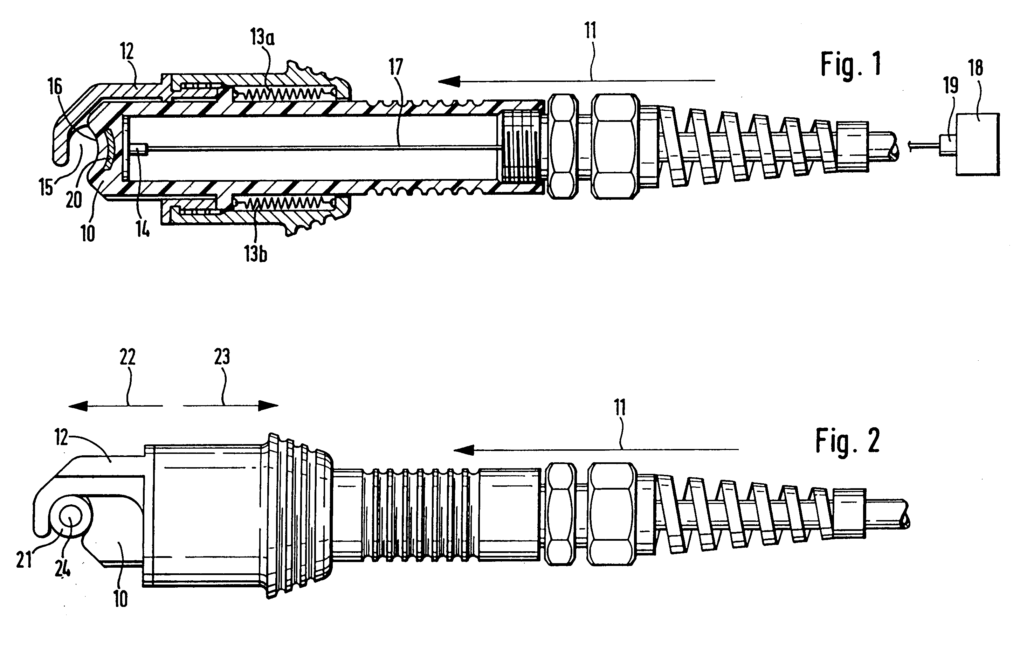

Figur 1 zeigt ein Schnittbild durch einen erfindungsgemäßen kapazitiven Sensor und Figur 2 zeigt eine Ansicht des kapazitiven Sensors, der an ein Hochspannungskabel geklemmt ist.

Figur 1 zeigt ein Schnittbild durch einen kapazitiven Sensor, der ein erstes Klemmteil 10 enthält, das eine Ausdehnung in eine Längsrichtung 11 aufweist. Ein zweites Klemmteil 12 ist gegenüber dem ersten Klemmteil 10 in der Längsrichtung 11 des ersten Klemmteils 10 verschiebbar. Beide Klemmteile 10, 12 sind über ein elastisches Element 13a, 13b miteinander verbunden. Das elastische Element 13a, 13b sind beispielsweise eine oder mehrere Federn. Bei einer gegebenenfalls vorgesehenen rotationsymmetrischen Ausgestaltung des kapazitiven Sensors bezogen auf die Längsrichtung 11 sind beispielsweise wenigstens zwei elastische Elemente 13a, 13b vorgesehen, die als Federn ausgestaltet sind. Besonders vorteilhaft bei der rotationsymmetrischen Ausgestaltung des kapazitiven Sensors ist der Einsatz einer einzigen Druckfeder, deren Windungen das erste Klemmteil 10 umgeben.

Im ersten Klemmteil 10 ist ein elektrisch leitfähiges Teil 14 angeordnet, das als eine erste Elektrode eines Kondensators zu betrachten ist, dessen andere Elektrode ein elektrischer Leiter in einem in Figur 1 nicht gezeigtem Hochspannungskabel ist. Das Hochspannungskabel wird in eine Klemmöffnung 15 zwischen dem ersten und zweiten Klemmteil 10, 12 gebracht, wobei die Klemmöffnung 15 in Abhängigkeit von der Verschiebung des zweiten Klemmteils 12 in Bezug auf das erste Klemmteil 10 unterschiedliche Abmessungen annehmen kann. Das Hochspannungskabel liegt nach dem Einklemmen an einer Auflagefläche 16 des ersten Klemmteils.

Das elektrisch leitfähige Teil 14 ist über eine Verbindungsleitung 17 mit einer Signalauswertevorrichtung 18 verbunden. Die Verbindung zur Signalauswertevorrichtung 18 erfolgt vorzugsweise über eine Steckverbindung 19.

Gemäß einer vorteilhaften Ausgestaltung ist im ersten Klemmteil 10 eine elektrisch leitfähige Schicht 20 vorgesehen, die zwischen dem elektrisch leitfähigen Teil 14 und der Auflagefläche 16 angeordnet ist. Die elektrisch leitfähige Schicht 20 umschließt zumindest teilweise das Hochspannungskabel. Die elektrisch leitfähige Schicht 20 erhöht die Koppelkapazität zwischen dem Hochspannungskabel und dem elektrisch leitfähigen Teil 14. Eine erhöhte Festigkeit gegenüber Hochspannungsüberschlägen oder Hochspannungsdurchschlägen ist dadurch gegeben, daß die elektrisch leitfähige Schicht 10 innerhalb des aus Isoliermaterial hergestellten ersten Klemmteils 10 angeordnet ist, wobei zwischen der elektrisch leitfähigen Schicht 20 und dem elektrisch leitfähigen Teil 14 ein Dielektrikum vorgesehen ist. Bei einer Reduzierung der Hochspannungsfestigkeit ist es auch möglich, die elektrisch leitfähige Schicht 20 unmittelbar an der Auflagefläche 16 anzuordnen.

In einer weiteren Ausgestaltung ist es möglich, das elektrisch leitfähige Teil 14 wegzulassen und die Verbindungsleitung 17 unmittelbar an die elektrisch leitfähigen Schicht 20 zu führen, die vorzugsweise innerhalb des ersten Klemmteils 10 oder auch unmittelbar an der Auflagefläche 16 angeordnet sein kann.

Figur 2 zeigt eine Ansicht des erfindungsgemäßen kapazitiven Sensors mit einem eingeklemmten Hochspannungskabel 21. Die Anpassung der Auflagefläche 16 an den Durchmesser des Hochspannungskabels 21 verhindert die Ausbildung eines Luftspalts zwischen dem Hochspannungskabel 21 und dem ersten Klemmteil 10. Selbst bei abweichenden Durchmessern der Hochspannungskabel 21 tritt kein Luftspalt auf.

In Figur 2 ist ein erster Pfeil 22 eingetragen, der einer Bewegungsrichtung des zweiten Teils 12 entspricht, die einem Erweitern der Klemmöffnung 15 zur Aufnahme des Hochspannungskabel 21 entspricht. Eingetragen ist ein zweiter Pfeil 23, dessen Bewegungsrichtung einem Festklemmen des Hochspannungskabels 21 in der Klemmöffnung 15 entspricht.

Das Hochspannungskabel 21 enthält einen elektrischen Leiter 24, der mit dem elektrisch leitfähigen Teil 14 oder mit der elektrisch leitfähigen Schicht 20, die jeweils im ersten Klemmteil 10 angeordnet sind, einen Kondensator mit berechenbarer oder experimentell bestimmbarer Kapazität bildet. Ein am Leiter 24 abfühlbares Spannungssignal wird kapazitiv, gegebenenfalls über die elektrisch leitfähige Schicht 20, auf das elektrisch leitfähige Teil 14 gekoppelt. Die Verbindungsleitung 17 bildet mit einer nicht gezeigten Gerätemasse, die auch als Abschirmung für die Verbindungsleitung 17 eingesetzt werden kann, einen weiteren Kondensator, derart, daß ein kapazitiver Spannungsteiler bezogen auf die Gerätemasse entsteht. Das an der Verbindungsleitung 17 anstehende Signal kann über die gegebenenfalls vorgesehene Steckverbindung 19 zur Signalauswertevorrichtung 18 übertragen werden. Als Signalauswertevorrichtung 18 ist beispielsweise ein Motortester vorgesehen, der vorzugsweise eine Überprüfung einer Zündanlage einer fremdgezündeten Brennkraftmaschine ermöglicht, bei der das Hochspannungskabel 21 als Zündleitung eingesetzt ist. Der erfindungsgemäße kapazitive Sensor ermöglicht eine bequeme Einhandbedienung und ein sicheres Festklemmen des Hochspannungskabels 21.

## Patentansprüche

1. Kapazitiver Sensor zum Erfassen von Hochspannungssignalen, der mit einem ersten Klemmteil und mit einem zweiten Klemmteil, welches mit dem ersten Klemmteil über ein elastisches Element verbunden ist, an ein Hochspannungskabel klemmbar ist, das beide Klemmteile kraftschlüssig zumindest teilweise umschließen, dadurch gekennzeichnet, daß das zweite Klemmteil (12) gegenüber dem ersten Klemmteil (10) in einer Längsrichtung (11) des ersten Klemmteils (10) verschiebbar ist und daß wenigstens im ersten Klemmteil (10) ein elektrisch leitfähiges Teil (14) und/oder eine elektrisch leitfähige Schicht (20) angeordnet sind, die mit dem Leiter (24) des Hochspannungskabels (16) Kondensatoren bilden.

2. Kapazitiver Sensor nach Anspruch 1, dadurch gekennzeichnet, daß die elektrisch leitfähige Schicht (20) zwischen dem elektisch leitfähigen Teil (14) und einer Auflagefläche (16) des Hochspannungskabels (21) angeordnet ist und daß zwischen der elektrisch leitfähigen Schicht (20) und dem elektrisch leitfähigen Teil (14) ein Dielektrikum vorgesehen ist.

3. Kapazitiver Sensor nach Anspruch 1, dadurch gekennzeichnet, daß das zweite Klemmteil (12) aus Isoliermaterial hergestellt ist.

4. Kapazitiver Sensor nach Anspruch 1, dadurch gekennzeichnet, daß das elastische Element (13a, 13b) wenigstens eine Feder ist.

5. Kapazitiver Sensor nach Anspruch 1, gekennzeichnet durch die Verwendung bei einem Motortester (18), der zur Überprüfung der Zündung einer fremdgezündeten Brennkraftmaschine vorgesehen ist.
